# EUROPEAN PATENT APPLICATION

(11) **EP 4 786 992 A1**
(43) Date of publication of application: **05.08.2026**
(21) Application number: 25155592.6
(22) Date of filing: 03.02.2025
(51) Int. Cl.: G01R 22/10

(54) **APPARATUS FOR AN ENERGY METER**

(71) Applicant: NXP B.V., 5656 AG Eindhoven (NL)
(72) Inventor: MIENKINA, Martin, 5656 AG Eindhoven (NL); VACULIK, Lukas, 5656 AG Eindhoven (NL)
(74) Representative: Schwarzweller, Thomas

(57) **Abstract**

An apparatus for an energy meter comprising: an input configured to receive one or more phases of an electricity supply for metering; an analogue to digital convertor, ADC, configured to sample one of the phases of the one or more phases at a sampling frequency to generate a plurality of samples comprising a digital representation of the one of the one or more phases;
a tuning block configured to:
determine a phase angle difference between:
(i) a first set of the plurality of samples representing a first voltage period of the one of the phases; and
(ii) a second set of the plurality of samples representing a second voltage period of the one of the phases; and

based on the phase angle difference, control the sampling frequency of the ADC.

## Description

### Field

The present disclosure relates to an apparatus for an energy meter. In particular, the disclosure relates to an apparatus for an energy meter configured to control a sampling frequency of an analogue to digital convertor. The disclosure also relates to an associated method.

### Backaround

The accurate metering of an electricity supply is a challenge.

### Summary

According to a first aspect of the present disclosure there is provided an apparatus for an energy meter comprising:
an input configured to receive one or more phases of an electricity supply for metering;
an analogue to digital convertor, ADC, configured to sample one of the phases of the one or more phases at a sampling frequency to generate a plurality of samples comprising a digital representation of the one of the one or more phases;
a tuning block configured to:
   determine a phase angle difference between:
   (i) a first set of the plurality of samples representing a first voltage period of the one of the phases; and
   (ii) a second set of the plurality of samples representing a second voltage period of the one of the phases; and
based on the phase angle difference, control the sampling frequency of the ADC.

In one or more embodiments, the tuning block is configured to control the sampling frequency of the ADC to reduce the phase angle difference for further sets of samples representing further voltage periods of the one of the phases, to thereby track changes in frequency of a voltage of the electricity supply.

In one or more embodiments, the apparatus comprises an FFT block configured to:
receive the plurality of samples of the one of the one or more phases;
divide the plurality of samples into at least the first set of the plurality of samples and the second set of the plurality of samples, wherein each of the first and second sets of the plurality of samples comprise a same, predetermined number of samples,
determine a fast Fourier transform of the first set of the plurality of samples, to determine a first real component and a first imaginary component representative of said first set of the plurality of samples;
determine a fast Fourier transform of the second set of the plurality of samples, to determine a second real component and a second imaginary component representative of said second set of the plurality of samples; and
wherein the tuning block is configured to:
determine a first phase angle based on the first real component and the first imaginary component;
determine a second phase angle based on the second real component and the second imaginary component; and
determine the phase angle difference based on a difference between the first phase angle and the second phase angle.

In one or more embodiments, the apparatus comprises a metering block configured to provide metering of the electricity supply at least based on the plurality of samples.

In one or more embodiments, the apparatus comprises a metering block configured to provide metering of the electricity supply at least based on the plurality of samples and wherein said FFT block comprises part of the metering block.

In one or more embodiments, the tuning block is configured to determine a first arctangent of a ratio of the first imaginary component to the first real component, and a second arctangent of a ratio of the second imaginary component to the second real component, and determine a difference between the first arctangent and the second arctangent to determine the .

In one or more embodiments, the second set of the plurality of samples and first set of the plurality of samples represent consecutive voltage cycles.

In one or more embodiments, the tuning block comprises an averaging component configured to determine a recent average of the phase angle difference for said control of the sampling frequency of the ADC.

In one or more embodiments, the averaging component comprises a proportion-integral controller.

In one or more embodiments, the apparatus comprises a clock, such as a phase locked loop, for providing a clock signal from which the sampling frequency of the ADC is derived, wherein the control provided by the tuning block is configured to control the frequency of the clock.

In one or more embodiments, the apparatus comprises a clock, such as a phase locked loop, for providing a clock signal and a fractional divider element configured to receive the clock signal and output a modified clock signal from which the sampling frequency of the ADC is derived, wherein the control provided by the tuning block is configured to control the fractional divider.

In one or more embodiments, the tuning block is configured to provide closed-loop control of the sampling frequency of the ADC.

In one or more embodiments, the tuning block includes a buffer to store a first phase angle of the first set of the plurality of samples representing the first voltage period, at least until receipt of a second phase angle of the second set of the plurality of samples and the determination of the phase angle difference.

According to a second aspect of the disclosure, there is provided an electricity meter including the apparatus of any first aspect.

According to a third aspect of the disclosure, there is provided method for controlling an electricity supply meter comprising:
receiving a first set of samples representing a first voltage period of one of one or more phases of an electricity supply to be metered, the first set of samples generated by an analogue to digital convertor, ADC, configured to sample at a sampling frequency;
receiving a second set of samples representing a second voltage period of the one of one or more phases, the second set of samples generated by the analogue to digital convertor, ADC, configured to sample at the sampling frequency;
determining a phase angle difference between:
   (i) the first set of samples representing the first voltage period of the one of the phases; and
   (ii) the second set of samples representing the second voltage period of the one of the phases; and
controlling the sampling frequency of the ADC based on the phase angle difference.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of an apparatus according to the disclosure;
Figure 2 shows the determination of a phase angle difference between voltage periods or cycles as represented by sets of samples of the voltage periods or cycles obtained at a sampling frequency;
Figure 3 shows an example metering block;
Figure 4 shows an example embodiment of a tuning block; and
Figure 5 shows a flowchart illustrating an example method.

### Detailed Description

The energy meter has evolved from a simple billing device to becoming an integral part of the electricity network, which monitors energy levels and helps with load management.

Energy meters may be electronic or electromechanical. However, electronic meters are now more common due to improved management and measuring of harmonic distortion which typically arises from the consumer's electrical equipment. Such harmonics produced by discontinuous conducting devices and non-linear loads create recognized problems for most power distribution systems.

Electronic energy meters are more accurate than electromechanical energy meters especially if they are subjected to the harmonic distortion. An electronic energy meter operates based on algorithms computed either in time or frequency domain. However, again, due to numerous electronic devices in house supplied from Switched Mode Power Supplies (SMPS) the preferred computing method is based on FFT algorithms (in the frequency domain) because they can provide Total Harmonics Distortion (THD) measurement in addition to energy metering data.

Electronic meters operating using FFT based algorithms are known. These meters require an exact number of voltage and/or current samples to be taken during each alternating voltage period, usually 64, 128 or 256 samples (and potentially for each phase for multi-phase electricity supplies). Measuring an exact number of samples for each voltage period is not easy because the voltage frequency of a mains electricity supply can drift. If the mains voltage frequency changes are not considered, the number of samples per period would vary, and then metering data would be inaccurate.

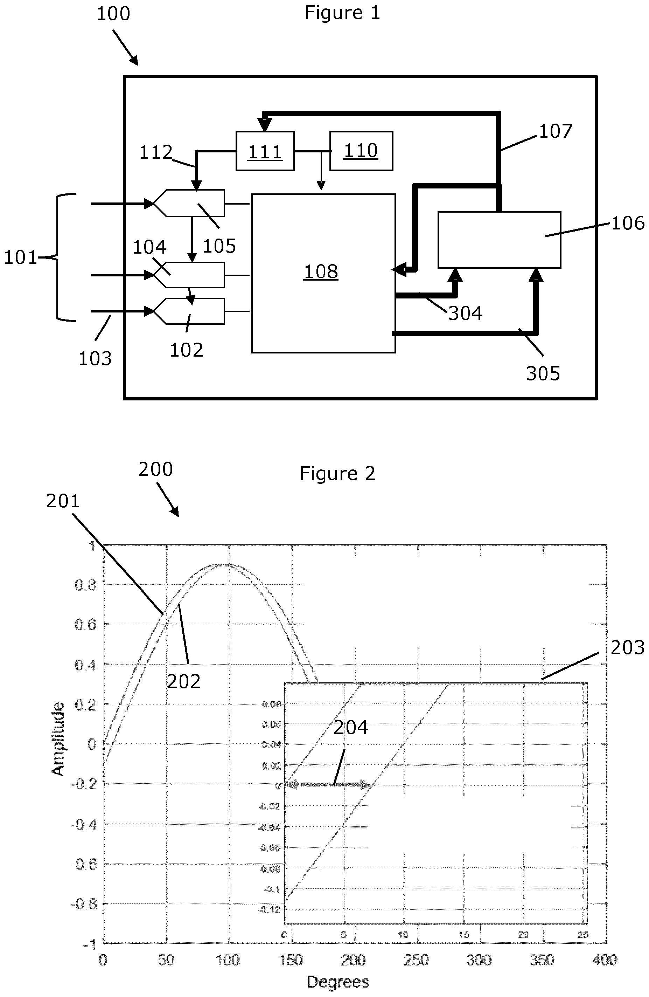

Figure 1 shows a first example apparatus 100, which in this example comprises part of an electricity meter or energy meter showing the components thereof relevant to the disclosure. The example of figure 1 shows the components for voltage measurements. However, it will be appreciated that the apparatus 100 may also make current measurements and similar functionality to that described below may be applied to the current measurements.

The apparatus 100 comprises an input 101 configured to receive one or more phases of an electricity supply for metering. In the present example, three phases are shown at the input 101 although, for simplicity, the remainder of the description will focus on one phase. The treatment of the other phases is similar.

The apparatus further comprises an analogue to digital convertor, ADC, 102 configured to sample the supply voltage from one of the phases 103. Further ADCs 104, 105 may be provided to sample the other phases received at input 101. Considering phase 103, the ADC 102 is configured to sample the voltage at an initial sampling frequency to generate a plurality of samples comprising a digital representation of the one of the one or more phases.

The initial sampling frequency may be a default setting or set to obtain a fixed number of samples for each voltage period based on a predetermined frequency of the phase.

The apparatus 100 may be configured to define sets of samples of said fixed number of samples to represent each voltage period, such as a first set of samples for a first voltage period and a second set of samples for a second, different voltage period. The first and second voltage periods may be consecutive voltage periods. Thus, the fixed number of samples in each of the first set and the second set should be, ideally, time and frequency aligned with the voltage period the set represents. However, if the frequency of the phase of the electricity supply varies, then the sets of samples are no longer representative of voltage periods having the same phase - there will be a phase angle difference between the voltage period represented by the first set and the voltage period represented by the second set.

The apparatus 100 further comprises a tuning block 106 configured to determine a phase angle difference between:
(i) the first set of the plurality of samples representing the first voltage period of the one of the phases; and
(ii) the second set of the plurality of samples representing the second voltage period of the one of the phases.

The tuning block 106 is configured to, based on the phase angle difference, control the sampling frequency of the ADC by way of a control signal 107.

Thus, advantageously, the phase angle difference may be used to control or tune the sampling frequency such that the analogue to digital convertor 102 generates future sets of samples that represent voltage periods of the phases with lower, or without a, phase angle difference. Thus, the tuning block is configured to control the sampling frequency of the ADC 102 to reduce the phase angle difference for further sets of samples representing further voltage periods of the one of the phases, to thereby track changes in frequency of a voltage of a phase of the electricity supply 103. Accordingly, the tuning block 105 may be configured to provide closed-loop control of the sampling frequency of the ADC 102.

The apparatus 100 of figure 1 further comprises a metering block 108 configured to provide metering, i.e. measurement, of the electricity supply at least based on the plurality of samples obtained by the ADC 102 (and any other ADCs 104, 105 that may be present). The metering block 108 in the present example is FFT based, in that it determines electricity usage based on taking FFTs of the sets of samples of the voltage periods. It will be appreciated that the apparatus 100 and, in particular, the metering block may also receive current samples for the computing of energy consumption. In one or more examples, the current based sampling may be based on the same sampling frequency as determined based on the voltage samples described herein.

The apparatus 100 further comprises a clock 110, such as a phase locked loop or other controlled oscillator, for providing a clock signal from which the sampling frequency of the ADC is derived. More particularly, a fractional divider element 111 is configured to receive the clock signal and output a modified clock signal from which the sampling frequency of the ADC is derived

A signal line 112 is shown representing the clock signal, which may or may not be modified by the fractional divider element 111, being used to establish the sampling frequency of the ADC 102, 104, 105.

Thus, the control provided by the tuning block 106 may be implemented in various ways. For example, the control provided by the tuning block 106 may be configured to control the frequency of the clock 110. In the present example, the control provided by the tuning block 106 is configured to control the fractional divider element 111. Accordingly, the output of tuning block 106 defines the setting of the fractional divider relative to the fixed frequency of the PLL 110. In other examples, the control provided by the tuning block 106 may directly control the sampling rate of the ADCs.

Figure 2 shows a graph illustrating the advantageous concept of measurement of the phase angle difference. Graph 200 shows amplitude versus angle and the first set of samples is plotted as line 201 and the second set of samples is plotted as line 202. Inset 203 shows a "zoomed-in" section of the graph 200.

Ideally, if the electricity supply frequency did not drift and the sampling frequency is capturing the same number of samples per voltage period, the lines 201 and 202 should be overlaid on one another.

However, with reference to inset 203, at the zero-crossing point, for example, there is phase offset of 7.0625 degrees in this example, shown by arrow 204. Obviously, other phase angle differences may be realised in practice.

This phase angle difference has been realised to be indicative of a drift in mains supply voltage frequency for the phase being measured and can be used to control the sampling frequency of the ADC to "track" the mains supply voltage frequency. It will be appreciated that it may be desired that the sampling frequency of the ADC is a function of the supply frequency such that the sampling by the ADC generates the correct sets of samples for use by the metering block 108.

The metering block 108, in the present example, includes components to determine a Fast Fourier transform, FFT, as part of the metering algorithm/process it performs. In the present example, the tuning block uses the output of an FFT to calculate the phase angle difference. Thus, in the present example, given that the metering block 108 is FFT based and includes the components to determine the FFT values required by the tuning block, the FFT processing is performed by the metering block. However, in an alternative example, the tuning block 106 may include its own "FFT block" to perform the FFT calculations.

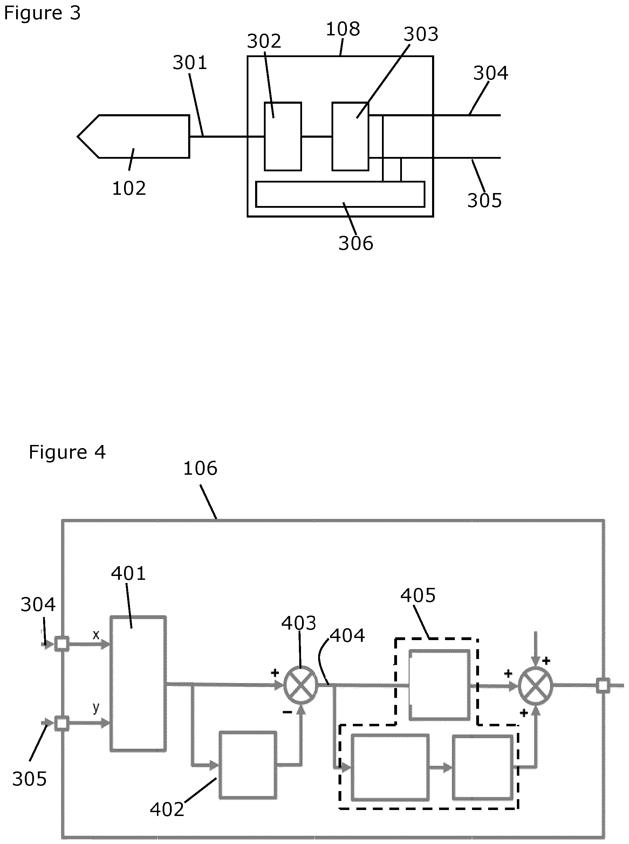

With reference to figure 3, the FFT determining elements of the metering block 108 comprise an input 301 to receive the plurality of samples determined by the ADC 102 (or other ADCs for the other phases if present), a buffer 302 and an FFT calculation block 303. The buffer 302 is configured to store the predetermined number of samples to represent a voltage period. The FFT calculation block is configured to calculate an FFT based on the set of samples from the buffer 302. The FFT calculation will be familiar to those skilled in the art and for the purposes here, the output will be a real component output 304 and an imaginary component output 305 representative of each set of the plurality of samples.

The real and imaginary components are also used for metering and further metering based components are shown generically as block 306.

Thus, the metering block 108 and tuning block 106 operate such that a fast Fourier transform of the first set of the plurality of samples is determined to generate a first real component and a first imaginary component representative of said first set of the plurality of samples. Likewise, a fast Fourier transform of the second set of the plurality of samples is determined to generate a second real component and a second imaginary component representative of said second set of the plurality of samples.

With reference to Figure 4, from the metering block 108, the tuning block 106, is provided with the first real component, the first imaginary component, the second real component and the second imaginary component from outputs 304, 305.

The tuning block 106 includes a phase angle determination block 401 configured to determine a first phase angle based on the first real component and the first imaginary component and determine a second phase angle based on the second real component and the second imaginary component.

In particular, if the real component is represented by X and the imaginary component is presented by Y, the phase angle determination block 401 is configured to determine the phase angle for each voltage period, which may be by calculating an arctangent of Y/X. In another example, the phase angle determination block may determine sin(X-Y), which may be approximated as X-Y for small angles. Thus, the phase angle determination block 401 at least is configured to determine a first phase angle for the first set of samples and a second phase angle for the second set of samples.

The first phase angle may be stored in a further buffer 402 so that a comparison can be made with the second phase angle once it is calculated. The tuning block 106 may comprise a difference element 403 configured to determine a difference between the first phase angle and the second phase angle which determines the phase angle difference at output 404.

In the present example, the tuning block comprises an averaging component 405, which may comprise a proportion-integral controller, configured to determine a recent average of the phase angle difference for said control of the sampling frequency of the ADC via output 107.

The proportion-integral controller 405 may be further configured to estimate the actual phase voltage frequency from the determined phase angle error. The proportion-integral controller 405 is configured to minimize angle error between phase angles of the two subsequent phase voltage periods in time and therefore compensating any voltage frequency changes in the mains electricity supply. Note that when phase angle error is zero then output of the PI controller will be the actual frequency of the phase voltage.

It will be appreciated that the tuning block may be provided as a controller for an electricity meter. Alternatively, the apparatus described herein may be part of an electricity meter.

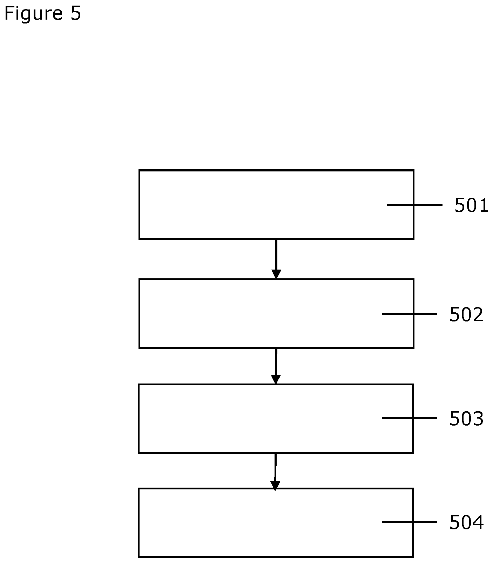

Figure 5 shows a method for controlling an electricity supply meter comprising:
receiving 501 a first set of samples representing a first voltage period of one of one or more phases of an electricity supply to be metered, the first set of samples generated by an analogue to digital convertor, ADC, configured to sample at a sampling frequency;
receiving 502 a second set of samples representing a second voltage period of the one of one or more phases, the second set of samples generated by the analogue to digital convertor, ADC, configured to sample at the sampling frequency;
determining 503 a phase angle difference between:
   (i) the first set of samples representing the first voltage period of the one of the phases; and
   (ii) the second set of samples representing the second voltage period of the one of the phases; and
controlling 504 the sampling frequency of the ADC based on the phase angle difference.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An apparatus for an energy meter comprising:
an input configured to receive one or more phases of an electricity supply for metering;
an analogue to digital convertor, ADC, configured to sample one of the phases of the one or more phases at a sampling frequency to generate a plurality of samples comprising a digital representation of the one of the one or more phases;
a tuning block configured to:
determine a phase angle difference between:
(i) a first set of the plurality of samples representing a first voltage period of the one of the phases; and
(ii) a second set of the plurality of samples representing a second voltage period of the one of the phases; and
based on the phase angle difference, control the sampling frequency of the ADC.

2. The apparatus of claim 1, wherein the tuning block is configured to control the sampling frequency of the ADC to reduce the phase angle difference for further sets of samples representing further voltage periods of the one of the phases, to thereby track changes in frequency of a voltage of the electricity supply.

3. The apparatus of claim 1 or claim 2, comprising
an FFT block configured to:
receive the plurality of samples of the one of the one or more phases;
divide the plurality of samples into at least the first set of the plurality of samples and the second set of the plurality of samples, wherein each of the first and second sets of the plurality of samples comprise a same, predetermined number of samples,
determine a fast Fourier transform of the first set of the plurality of samples, to determine a first real component and a first imaginary component representative of said first set of the plurality of samples;
determine a fast Fourier transform of the second set of the plurality of samples, to determine a second real component and a second imaginary component representative of said second set of the plurality of samples; and
wherein the tuning block is configured to:
determine a first phase angle based on the first real component and the first imaginary component;
determine a second phase angle based on the second real component and the second imaginary component; and
determine the phase angle difference based on a difference between the first phase angle and the second phase angle.

4. The apparatus of any preceding claim, comprising a metering block configured to provide metering of the electricity supply at least based on the plurality of samples.

5. The apparatus of claim 3, comprising a metering block configured to provide metering of the electricity supply at least based on the plurality of samples and wherein said FFT block comprises part of the metering block.

6. The apparatus of claim 3 or 5, wherein the tuning block is configured to determine a first arctangent of a ratio of the first imaginary component to the first real component, and a second arctangent of a ratio of the second imaginary component to the second real component, and determine a difference between the first arctangent and the second arctangent to determine the .

7. The apparatus of any preceding claim, wherein the second set of the plurality of samples and first set of the plurality of samples represent consecutive voltage cycles.

8. The apparatus of any preceding claim, wherein the tuning block comprises an averaging component configured to determine a recent average of the phase angle difference for said control of the sampling frequency of the ADC.

9. The apparatus of claim 8, wherein the averaging component comprises a proportion-integral controller.

10. The apparatus of any preceding claim, comprising a clock, such as a phase locked loop, for providing a clock signal from which the sampling frequency of the ADC is derived, wherein the control provided by the tuning block is configured to control the frequency of the clock.

11. The apparatus of any preceding claim, comprising a clock, such as a phase locked loop, for providing a clock signal and a fractional divider element configured to receive the clock signal and output a modified clock signal from which the sampling frequency of the ADC is derived, wherein the control provided by the tuning block is configured to control the fractional divider.

12. The apparatus of any preceding claim, wherein the tuning block is configured to provide closed-loop control of the sampling frequency of the ADC.

13. The apparatus of any preceding claim, wherein the tuning block includes a buffer to store a first phase angle of the first set of the plurality of samples representing the first voltage period, at least until receipt of a second phase angle of the second set of the plurality of samples and the determination of the phase angle difference.

14. An electricity meter including the apparatus of any preceding claim.

15. A method for controlling an electricity supply meter comprising:
receiving a first set of samples representing a first voltage period of one of one or more phases of an electricity supply to be metered, the first set of samples generated by an analogue to digital convertor, ADC, configured to sample at a sampling frequency;
receiving a second set of samples representing a second voltage period of the one of one or more phases, the second set of samples generated by the analogue to digital convertor, ADC, configured to sample at the sampling frequency;
determining a phase angle difference between:
(i) the first set of samples representing the first voltage period of the one of the phases; and
(ii) the second set of samples representing the second voltage period of the one of the phases; and
controlling the sampling frequency of the ADC based on the phase angle difference.

## Amended claims

### Amended claims in accordance with Rule 137(2) EPC.

1. An apparatus (100) for an energy meter comprising:
an input (101) configured to receive one or more phases (103) of an electricity supply for metering;
an analogue to digital convertor, ADC, (102, 104, 105) configured to sample one of the phases (103) of the one or more phases (103) at a sampling frequency to generate a plurality of samples comprising a digital representation of the one of the one or more phases (103);
a tuning block (106) configured to:
determine a phase angle difference between:
(i) a first set of the plurality of samples representing a first voltage period of the one of the phases (103); and
(ii) a second set of the plurality of samples representing a second voltage period of the one of the phases (103); and
based on the phase angle difference, control the sampling frequency of the ADC, wherein the tuning block (106) comprises an averaging component (405) configured to determine a recent average of the phase angle difference for said control of the sampling frequency of the ADC.

2. The apparatus (100) of claim 1, wherein the tuning block (106) is configured to control the sampling frequency of the ADC (102, 104, 105) to reduce the phase angle difference for further sets of samples representing further voltage periods of the one of the phases (103), to thereby track changes in frequency of a voltage of the electricity supply.

3. The apparatus (100) of claim 1 or claim 2, comprising an FFT block configured to:
receive the plurality of samples of the one of the one or more phases (103);
divide the plurality of samples into at least the first set of the plurality of samples and the second set of the plurality of samples, wherein each of the first and second sets of the plurality of samples comprise a same, predetermined number of samples,
determine a fast Fourier transform of the first set of the plurality of samples, to determine a first real component and a first imaginary component representative of said first set of the plurality of samples;
determine a fast Fourier transform of the second set of the plurality of samples, to determine a second real component and a second imaginary component representative of said second set of the plurality of samples; and
wherein the tuning block (106) is configured to:
determine a first phase angle based on the first real component and the first imaginary component;
determine a second phase angle based on the second real component and the second imaginary component; and
determine the phase angle difference based on a difference between the first phase angle and the second phase angle.

4. The apparatus (100) of any preceding claim, comprising a metering block (108) configured to provide metering of the electricity supply at least based on the plurality of samples.

5. The apparatus (100) of claim 3, comprising a metering block configured to provide metering of the electricity supply at least based on the plurality of samples and wherein said FFT block comprises part of the metering block.

6. The apparatus (100) of claim 3 or 5, wherein the tuning block (106) is configured to determine a first arctangent of a ratio of the first imaginary component to the first real component, and a second arctangent of a ratio of the second imaginary component to the second real component, and determine a difference between the first arctangent and the second arctangent to determine the phase angle difference between the first set and the second set of the plurality of samples.

7. The apparatus (100) of any preceding claim, wherein the second set of the plurality of samples and first set of the plurality of samples represent consecutive voltage cycles.

8. The apparatus (100) of claim 1, wherein the averaging component (405) comprises a proportion-integral controller.

9. The apparatus (100) of any preceding claim, comprising a clock (110), such as a phase locked loop, for providing a clock signal from which the sampling frequency of the ADC (102, 104, 105) is derived, wherein the control provided by the tuning block (106) is configured to control the frequency of the clock.

10. The apparatus (100) of any preceding claim, comprising a clock, such as a phase locked loop, for providing a clock signal and a fractional divider element (111) configured to receive the clock signal and output a modified clock signal from which the sampling frequency of the ADC is derived, wherein the control provided by the tuning block (106) is configured to control the fractional divider.

11. The apparatus (100) of any preceding claim, wherein the tuning block is configured to provide closed-loop control of the sampling frequency of the ADC (102, 104, 105).

12. The apparatus (100) of any preceding claim, wherein the tuning block (106) includes a buffer (302) to store a first phase angle of the first set of the plurality of samples representing the first voltage period, at least until receipt of a second phase angle of the second set of the plurality of samples and the determination of the phase angle difference.

13. An electricity meter including the apparatus (100) of any preceding claim.

14. A method for controlling an electricity supply meter comprising:
receiving a first set of samples representing a first voltage period of one of one or more phases (103) of an electricity supply to be metered, the first set of samples generated by an analogue to digital convertor, ADC, configured to sample at a sampling frequency;
receiving a second set of samples representing a second voltage period of the one of one or more phases (103), the second set of samples generated by the analogue to digital convertor, ADC, configured to sample at the sampling frequency;
determining a phase angle difference between:
(i) the first set of samples representing the first voltage period of the one of the phases (103); and
(ii) the second set of samples representing the second voltage period of the one of the phases (103); and
controlling the sampling frequency of the ADC based on the phase angle difference, wherein method comprises determining a recent average of the phase angle difference for said controlling of the sampling frequency of the ADC.
